# EUROPEAN PATENT SPECIFICATION

(11) **EP 3 547 020 B1**
(45) Date of publication and mention of the grant of the patent: **28.12.2022**
(21) Application number: 19164010.1
(22) Date of filing: 20.03.2019
(51) Int. Cl.: G02F 1/1345, H05K 1/11, H05K 3/32

(54) **DISPLAY DEVICE INCLUDING AN ANISOTROPIC CONDUCTIVE FILM**
ANZEIGEVORRICHTUNG MIT EINER ANISOTROPEN LEITFÄHIGEN FOLIE
DISPOSITIF D'AFFICHAGE COMPRENANT UN FILM CONDUCTEUR ANISOTROPE

(30) Priority: 30.03.2018 KR 20180037625
(43) Date of publication of application: 02.10.2019
(73) Proprietor: Samsung Display Co., Ltd., Gyeonggi-Do (KR)
(72) Inventor: Lee, Chung Seok, Hwaseong-si, Gyeonggi-do (KR); Heo, Kyeong Yeol, 31156 Cheonan-si, Chungcheongnam-do (KR)
(74) Representative: Gulde & Partner

(56) References cited:
- KR-A- 20170 134 679
- US-A1- 2015 103 500
- US-A1- 2017 271 293

## Description

### TECHNICAL FIELD

The present disclosure relates to a display device and, more specifically, to a display device having an anisotropic conductive film.

### DISCUSSION OF THE RELATED ART

A display device is a machine configured to display an image, or a sequence of images, in response to a signal. Display devices are widely used in televisions, computer monitors, a personal digital assistants (PDAs), smart phones, personal computers (PCs), tablet computers, and other stationary and mobile devices.

The display device may include a display panel and a printed circuit board configured for driving the display panel. The printed circuit board and the display panel may be electrically connected to each other through an anisotropic conductive film (ACF) or the like.

An ACF includes conductive particles arranged within an insulating layer such as a resin layer. Because of the arrangement of the conductive particles, electricity may be conducted in a thickness direction of the ACF, while electricity is insulated in a surface direction (e.g. lengthwise direction) of the ACF.

US 2017/271293 A1 discloses a display device with an ACF.

### SUMMARY

According to the present invention, it is provided with a display device as defined in claim 1. Further embodiments are defined in the dependent claims.

### BRIEF DESCRIPTION OF THE DRAWINGS

The above and other aspects and features of the present disclosure will become more apparent by describing exemplary embodiments thereof in detail with reference to the attached drawings, in which:
FIGS. 1 and 2 are plan views illustrating a bonding process of a display panel and a printed circuit board in a display device according to an embodiment of the invention;
FIG. 3 is an enlarged plan view illustrating a portion Q1 of FIG. 1;
FIG. 4 is an enlarged plan view illustrating a portion Q2 of FIG. 1;
FIG. 5 is a schematic cross-sectional view illustrating the display device of FIG. 4 taken along line A1-A1' in a state in which the display panel and the printed circuit board are coupled;
FIG. 6 is a plan view illustrating a portion of an anisotropic conductive film shown in FIG. 2;
FIG. 7 is an enlarged plan view illustrating a rectangular portion shown in FIG. 6;
FIG. 8 is a plan view illustrating conductive particles of an anisotropic conductive film with a first specific pad in a display device according to an embodiment of the invention;
FIG. 9 is a plan view illustrating conductive particles of an anisotropic conductive film and a first specific pad together in a display device according to a comparative example;
FIG. 10 is a plan view illustrating conductive particles of an anisotropic conductive film and a first specific pad together in a display device according to a comparative example;
FIG. 11 is a plan view illustrating a first specific pad of FIG. 8;
FIG. 12 is a plan view illustrating a first connection electrode corresponding to the first specific pad of FIG. 8;
FIG. 13 is an equivalent circuit diagram illustrating a pixel of FIG. 1;
FIG. 14 is a plan view schematic circuit diagram illustrating a pixel of FIG. 1;
FIG. 15 is a cross-sectional view taken along line A2-A2' of FIG. 14; and
FIGS. 16 and 17 are plan views illustrating a bonding process of a display panel and a printed circuit board in a display device according to an embodiment of the invention.

### DETAILED DESCRIPTION OF THE EMBODIMENTS

In describing embodiments of the present disclosure illustrated in the drawings specific terminology is employed for sake of clarity. The present disclosure may, however, be embodied in many different forms and should not be construed as being limited to the exemplary embodiments set forth herein. Rather, these exemplary embodiments are provided so that this disclosure will be thorough and complete and will fully convey the concept of the present disclosure to those skilled in the art.

Cases where elements or layers are referred to as being located "on" other elements or layers include all the cases where other layers or other elements are interposed directly on or between other elements. Same reference numerals may refer to the same constituent elements throughout the specification and drawings.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present invention.

Hereinafter, embodiments of the present invention will be described with reference to the accompanying drawings.

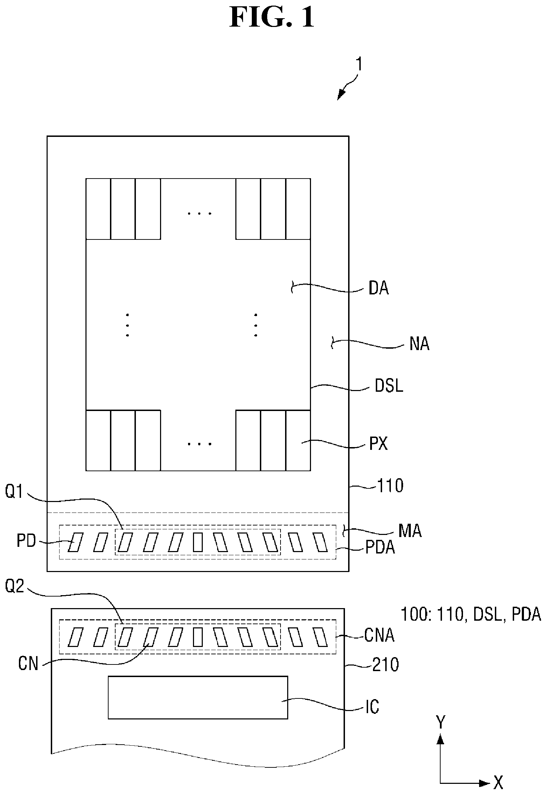

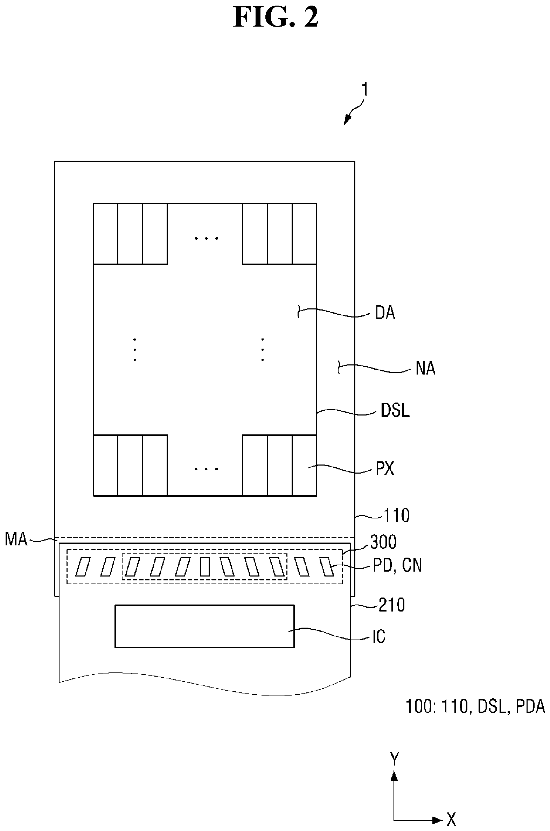

FIGS. 1 and 2 are plan views illustrating a bonding process of a display panel and a printed circuit board in a display device according to an embodiment of the invention.

Referring to FIG. 1, a display device 1 may include a display panel 100, a printed circuit board 210, and a data driving integrated circuit (IC).

The display panel 100 may have a rectangular shape in the plan view. The display panel 100 may include two short sides extending along an X axis and two long sides extending along a Y axis that is perpendicular to the X axis. The corners of the display panel 100, at which the long sides and the short sides of the display panel 100 meet, may be right angles, but may alternatively be curved. A planar shape of the display panel 100 is not limited to that shown, and may be a circular shape or another shape such as an arbitrary shape.

The display panel 100 includes a display region DA displaying an image and a non-display region NA that does not display an image. The non-display region NA may be disposed in a periphery of the display region DA and may at least partially surround the display region DA.

A portion of the non-display region NA of the display panel 100 may be a pad region MA to which the printed circuit board 210 is coupled. In embodiments of the invention, the pad region MA may be disposed below the display panel 100 in the non-display region NA.

The display panel 100 may have a stacked structure including a base substrate 110, a display element layer DSL, and a pad portion PDA.

The base substrate 110 may be made of an insulating material such as glass, quartz, a polymer resin, or the like. For example, the polymer material may include polyethersulphone (PES), polyacrylate (PA), polyarylate (PAR), polyetherimide (PEI), polyethylenenapthalate (PEN), polyethyleneterepthalate (PET), polyphenylenesulfide (PPS), polyallylate, polyimide (PI), polycarbonate (PC), cellulosetriacetate (CAT), cellulose acetate propionate (CAP), or a combination thereof. The base substrate 110 may include a metal.

The base substrate 110 may be a rigid substrate, which does not bend, or a flexible substrate, which is capable of being bent, folded, rolled, and the like. A material of the flexible substrate may be, for example, PI, but the present disclosure is not limited thereto.

The display element layer DSL may be disposed on the base substrate 110 in the display region DA. The display element layer DSL may include a plurality of pixels PX, and each of the pixels PX may be an element for displaying a portion of an image. In embodiments of the invention, each of the pixels PX may include an organic light-emitting diode.

The pad portion PDA is disposed on the base substrate 110 in the pad region MA of the non-display region NA. The pad portion PDA may include a plurality of pads PD for receiving signals supplied from the printed circuit board 210.

When a data driving IC for supplying a data signal to the pixel PX is mounted on the display panel 100 in the form of a chip, the pads PD may be used for supplying display data and control signals to the data driving IC. When the data driving IC is mounted on the printed circuit board 210 in the form of a chip, the pads PD may include data pads, which are electrically connected to data lines which supply data signals to the pixels PX, and control signal pads, which are electrically connected to control signal wires through which control signals are supplied to the data driving IC.

In some embodiments of the invention, the printed circuit board 210 may be a flexible printed circuit board. In some embodiments of the invention, as shown in FIG. 1, a connection electrode portion CNA corresponding to the pad portion PDA may be disposed on a rear surface of the printed circuit board 210, for example, a surface facing the display panel 100. The connection electrode portion CNA may include a plurality of connection electrodes CN for being electrically connected to the pads PD in one-to-one correspondence.

For example, a chip-on-film structure in which the data driving IC is mounted on the flexible printed circuit board 210 is shown in FIG. 1.

Referring to FIG. 2, the printed circuit board 210 is coupled to the pad region MA of the display panel 100. An anisotropic conductive film 300 is disposed between the display panel 100 and the printed circuit board 210, and the display panel 100 and the printed circuit board 210 may be physically/electrically coupled to each other through the anisotropic conductive film 300.

The anisotropic conductive film 300 is an adhesive film used for circuit connection and has anisotropic properties that conduct electricity in one direction (e.g., in a thickness direction) and insulate electricity in another direction (e.g., in a surface direction). The anisotropic conductive film 300 includes an insulating layer (e.g., a thermosetting insulating layer) having adhesiveness and a plurality of conductive particles disposed within the insulating layer.

When the connection electrodes CN of the printed circuit board 210 and the pads PD of the display panel 100 are arranged to face each other, the anisotropic conductive film 300 is interposed between the printed circuit board 210 and the display panel 100. Thereafter, when heat and pressure are applied to the pad region MA of the display panel 100 by a tool, the conductive particles of the anisotropic conductive film 300 are in contact with the connection electrodes CN and the pads PD, and accordingly, the printed circuit board 210 and the display panel 100 are electrically connected to each other. Further, when the insulating layer of the anisotropic conductive film 300 is cured, the printed circuit board 210 is attached to the display panel 100.

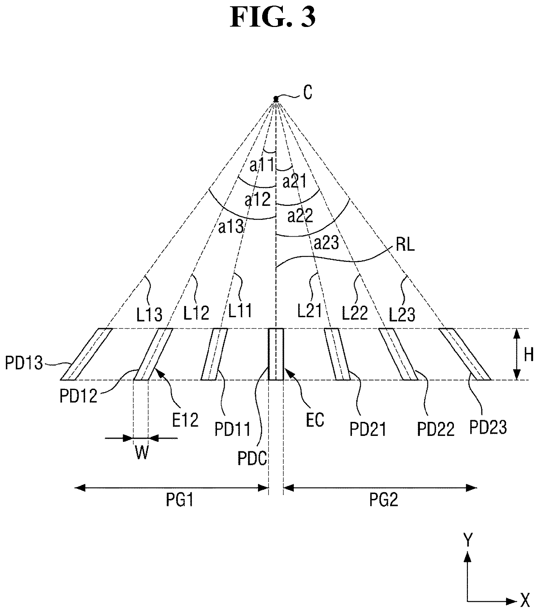

FIG. 3 is an enlarged plan view illustrating a portion Q1 of FIG. 1, and shows various shapes of the pads disposed in the display panel.

Referring to FIGS. 1 and 3, a first pad group PG1 may be disposed at a left side of the pad region MA of the display panel 100 with respect to a central line RL parallel to the Y axis. A second pad group PG2 may be disposed at a right side of the pad region MA of the display panel 100. According to an exemplary embodiment of the present disclosure, there are two pad groups: the first pad group PG1 and the second pad group PG2. Further, a plurality of central lines RL may be disposed on the display panel 100. Pad groups may be arranged in the same manner for each central line RL. However, for convenience of description, one central line RL is shown in the drawings below.

The first pad group (PG1) will be referred to a first pad (PG1) and the second pad group (PG2) will be referred to a second pad (PG2) for example, in the claims, which is for sake of simplicity of the description. The first pad (PG1) does not refer to a specific pad but to a representative pad included in the first pad group. The pads included in the first pad group share substantial characteristics. Thus, any pad included in the first pad group can be the representative pad. It is also the case at the pads included in the second pad group.

The first pad group PG1 may include a plurality of pads which extend along a line which forms an acute angle with respect to the central line RL.

For example, the first pad group PG1 may include a first pad PD11 which extends along a first line L11, a second pad PD12 which extends along a second line L12, and a third pad PD13 which extends along a third line L13. In some exemplary embodiments of the present disclosure, the first line L11, the second line L12, and the third line L13 may converge on the same reference point C along with the central line RL, and each of the first line L11, the second line L12, and the third line L13 may have a positive slope on a plane formed by the X axis and the Y axis. An acute angle formed by the first line L11 and the central line RL may be a first angle a11, an acute angle formed by the second line L12 and the central line RL may be a second angle a12, and an acute angle formed by the third line L13 and the central line RL may be a third angle a13. Each of the first angle a11, the second angle a12, and the third angle a13 may be greater than 0°.

The first pad PD11, the second pad PD12, and the third pad PD13 may be arranged substantially parallel to the X axis, and may be sequentially arranged.

Each of the first pad PD11, the second pad PD12, and the third pad PD13 may have a parallelogram shape, and a base of the parallelogram may be parallel to the X axis and a height of the parallelogram may be a length in a Y axis direction. Each of the first pad PD11, the second pad PD12, and the third pad PD13 may have a parallelogram shape in which a height is greater than a length of a base. For example, when the second pad PD12 is referred to as a first specific pad, a height H of the first specific pad PD12 may be greater than a width W of the base of the first specific pad PD12. For example, each of the first pad PD11, the second pad PD12, and the third pad PD13 may have a parallelogram shape elongated in the Y axis direction. Hereinafter, the "first specific pad" will be referred to as the "the second pad PD12."

Each of the first pad PD11, the second pad PD12, and the third pad PD13 may be obliquely tilted with respect to the Y axis, and may each include a lateral side having an acute angle greater than 0° with respect to the Y axis.

For example, a lateral side E12 of the second pad PD12 may have an acute angle greater than 0° with respect to the Y axis or the central line RL parallel to the Y axis. Further, the lateral side E12 of the second pad PD12 may be parallel to the second line L12. Therefore, the acute angle formed by the lateral side E12 of the second pad PD12 and the Y axis may be substantially the same as the second angle a12 formed by the second line L12 and the central line RL.

Similarly, an acute angle formed by a lateral side of the first pad PD11 and the Y axis may be the first angle a11, and an acute angle formed by a lateral side of the third pad PD13 and the Y axis may be the third angle a13.

In some embodiments of the invention, each of the first angle a11, the second angle a12, and the third angle a13 may have an angle being greater than 0° and less than or equal to 20°. Further, in some exemplary embodiments of the present disclosure, the second angle a12 of the first specific pad PD12 may be greater than 5° and less than or equal to 20°. For example, the first specific pad PD12 may be defined as a pad of which an acute angle formed by a lateral side and the Y axis is greater 5° and less than or equal to 20°, among the pads in the first pad group PG1. As will be described below, when the second angle a12 of the first specific pad PD12 is greater than 5°, an arrangement of the conductive particles 330 is determined in consideration of the second angle a12 of the first specific pad PD12 in order to increase the reliability of electrical connection. An upper limit of the second angle a12 of the first specific pad PD12 may be appropriately selected according to the structure of the display device 1, and for example, the second angle a12 may be 20° or less.

An acute angle formed by each of lateral sides of the pads and the Y axis may increase from the central line RL toward an edge of the display panel 100 in an X axis direction.

For example, among the first pad PD11, the second pad PD12, and the third pad PD13, the third pad PD13 is the closest to the edge of the display panel 100 in the X axis direction, and the first pad PD11 is the closest to the central line RL. Further, the second pad PD12 is disposed between the first pad PD11 and the third pad PD13. In this case, the first angle a11 formed by the lateral side of the first pad PD11 and the Y axis may be smaller than the second angle a12 formed by the lateral side of the second pad PD12 and the Y axis, and the third angle a13 formed by the lateral side of the third pad PD13 and the Y axis may be greater than the second angle a12.

The second pad group PG2 may include a fourth pad PD21, a fifth pad PD22, and a sixth pad PD23. The fourth pad PD21 may extend along a fourth line L21 symmetrical to the first line L11 relative to the central line RL, the fifth pad PD22 may extend along a fifth line L22 symmetrical to the second line L12 relative to the central line RL, and the sixth pad PD23 may extend along a sixth line L23 symmetrical to the third line L13 relative to the central line RL. In some exemplary embodiments of the present disclosure, the fourth line L21, the fifth line L22, and the sixth line L23 may converge on the same reference point C along with the central line RL like the first line L11, the second line L12, and the third line L13, and have a negative slope on the plane formed by the X axis and the Y axis.

An acute angle formed by the central line RL and the fourth line L21 may be a fourth angle a21, and the fourth angle a21 may be the same as the first angle a11. Similarly, a fifth angle a22, which is an acute angle formed by the central line RL and the fifth line L22, may be the same as the second angle a12, and a sixth angle a23, which is an acute angle formed by the central line RL and the sixth line L23, may be the same as the third angle a13.

The fourth pad PD21, the fifth pad PD22, and the sixth pad PD23 may be respectively symmetrical to the first pad PD11, the second pad PD12, and the third pad PD13 on the basis of the Y axis or the central line RL parallel to the Y axis. Therefore, an acute angle formed by a lateral side of each of the fourth pad PD21, the fifth pad PD22, and the sixth pad PD23 and the Y axis may increase toward the edge of the display panel 100 in the X axis direction.

In some embodiments of the invention, the display panel 100 may further include a reference pad PDC having a lateral side EC parallel to the central line RL. The reference pad PDC may be disposed between the first pad group PG1 and the second pad group PG2, and the central line RL parallel to the Y axis may pass through the reference pad PDC.

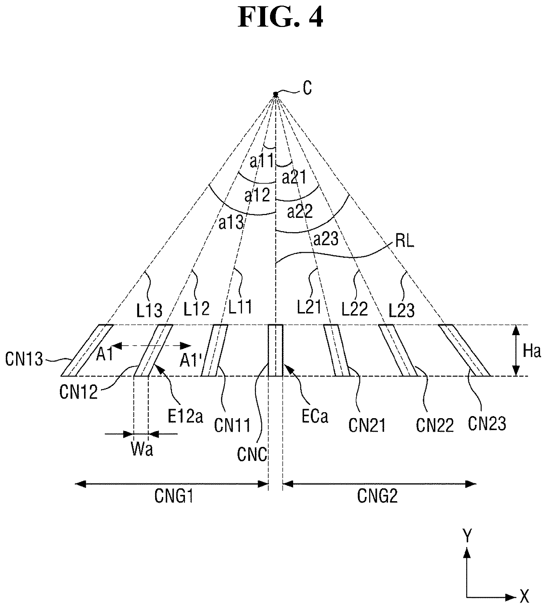

FIG. 4 is an enlarged plan view illustrating a portion Q2 of FIG. 1.

Referring to FIGS. 1 and 4, a first electrode group CNG1 may be disposed at a left side of the connection electrode portion CNA on the rear surface of the printed circuit board 210 (e.g., the surface facing the display panel 100) with respect to the central line RL parallel to the Y axis, and a second electrode group CNG2 may be disposed at a right side of the connection electrode portion CNA.

The first electrode group CNG1 may include a first connection electrode CN11 having a structure corresponding to the first pad PD11, a second connection electrode CN12 having a structure corresponding to the second pad PD12, and a third connection electrode CN13 having a structure corresponding to the third pad PD13. The first connection electrode CN11, the second connection electrode CN12, and the third connection electrode CN13 may have a parallelogramical shape having a height greater than a length of a base like the first pad PD11, the second pad PD12, and the third pad PD13.

For example, when the second connection electrode CN12 corresponding to the first specific pad PD12 is referred to as a first specific connection electrode, a height Ha of the first specific connection electrode CN12 may be greater than a width Wa of a base of the first specific connection electrode CN12. In some exemplary embodiments of the present disclosure, the height Ha of the first specific connection electrode CN12 may be the same as the height H of the first specific pad PD12 and the width Wa of the base of the first specific connection electrode CN12 may be substantially the same as the width W of the base of the first specific pad PD12, but the present disclosure is not limited thereto and the first specific pad PD12 and the first specific connection electrode CN12 may have different arrangements.

The first connection electrode CN11 may have a structure corresponding to the first pad PD11, the second connection electrode CN12 may have a structure corresponding to the second pad PD12, and the third connection electrode CN13 may have a structure corresponding to the third pad PD13. Therefore, in some exemplary embodiments of the present disclosure, an acute angle formed by a lateral side E12a of the first specific connection electrode CN12 corresponding to the first specific pad PD12 and the Y axis may be the second angle a12, which is equal to the acute angle formed by the lateral side E12 of the first specific pad PD12 and the Y axis.

The second electrode group CNG2 may include a fourth connection electrode CN21 having a structure corresponding to the fourth pad PD21, a fifth connection electrode CN22 having a structure corresponding to the fifth pad PD22, and a sixth connection electrode CN23 having a structure corresponding to the sixth pad PD23.

In addition, a description of each of the connection electrodes of the printed circuit board 210 is substantially the same as or similar to the description of each of the pads of the display panel 100.

In some embodiments of the invention, the connection electrode portion CNA of the printed circuit board 210 may further include a reference electrode CNC corresponding to the reference pad PDC. The reference electrode CNC may be disposed between the first electrode group CNG1 and the second electrode group CNG2, and the central line RL parallel to the Y axis may pass through the reference electrode CNC. Further, a lateral side ECa of the reference electrode CNC may be parallel to the Y axis or the central line RL.

In the display device 1, according to an embodiment of the invention, the pads of the display panel 100 and the connection electrodes of the printed circuit board 210 are arranged obliquely with respect to the Y axis. Accordingly, an alignment margin between the display panel 100 and the printed circuit board 210 may be secured.

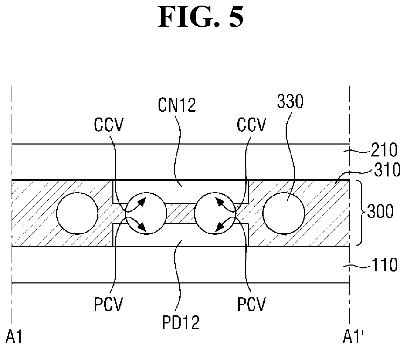

FIG. 5 is a schematic cross-sectional view of the display device taken along line A1-A1' of FIG. 4 in a state in which the display panel and the printed circuit board are coupled.

Referring to FIG. 5, the anisotropic conductive film 300 is disposed between the first specific pad PD12 and the first specific connection electrode CN12.

The anisotropic conductive film 300 includes an insulating layer 310 and a plurality of conductive particles 330 disposed in the insulating layer 310 as described above. Some of the conductive particles 330 are disposed between the first specific pad PD12 and the first specific connection electrode CN12 and are in contact with the first specific pad PD12 and the first specific connection electrode CN12, and accordingly, the first specific pad PD12 and the first specific connection electrode CN12 are electrically connected. In some embodiments of the invention, a plurality of conductive particles 330 may be disposed between the first specific pad PD12 and the first specific connection electrode CN12.

In the process of coupling the display panel 100 and the printed circuit board 210, pressure as well as heat is applied to the anisotropic conductive film 300. Accordingly, traces pressed by the conductive particles 330, which may be, a plurality of pad concave portions PCV, are formed in the first specific pad PD12. Similarly, traces pressed by the conductive particles 330, which may be, a plurality of electrode concave portions CCV, are formed in the first specific connection electrode CN12.

The electrode concave portions CCV and the pad concave portions PCV are formed at positions corresponding to the conductive particles 330 disposed between the first specific pad PD12 and the first specific connection electrode CN12. For example, the pad concave portions PCV and the electrode concave portions CCV may be formed at positions corresponding to each other and may at least partially overlap each other. Further, the conductive particles 330 may be disposed between the pad concave portions PCV and the electrode concave portions CCV. Further, the conductive particles 330 disposed between the first specific pad PD12 and the first specific connection electrode CN12 may simultaneously overlap the pad concave portions PCV and the electrode concave portions CCV.

When the conductive particles 330 are arranged at regular intervals, the pad concave portions PCV formed in the first specific pad PD12 may be arranged to have substantially the same arrangement as the conductive particles 330, and the electrode concave portions CCV formed in the first specific connection electrode CN12 may also be arranged to have substantially the same arrangement as the conductive particles 330.

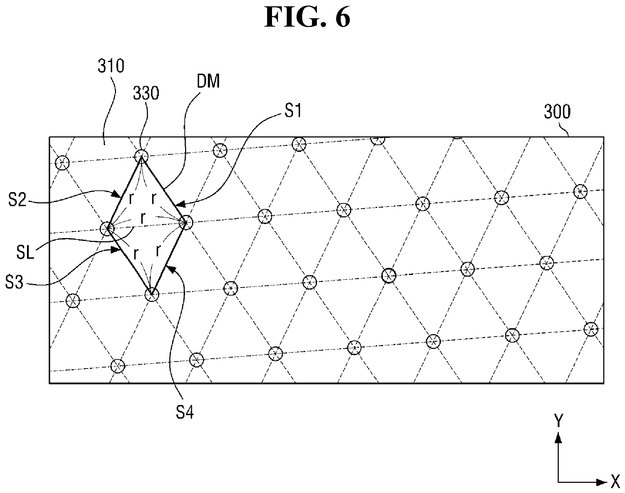

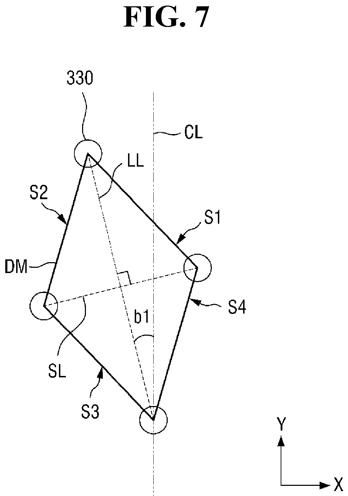

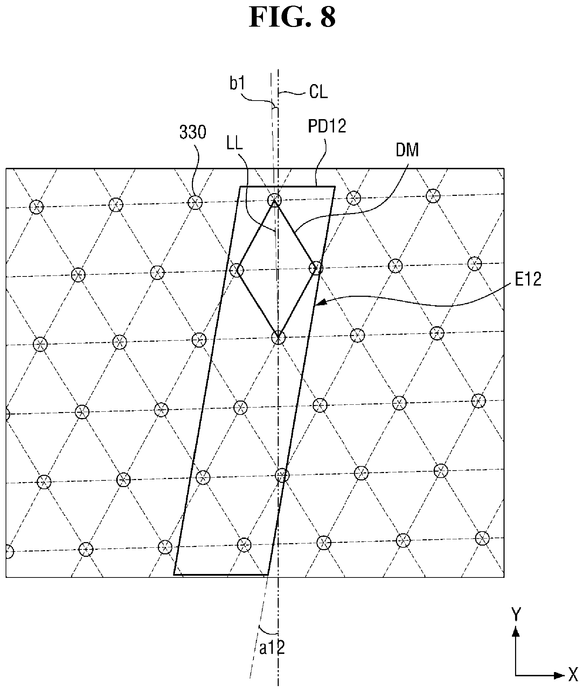

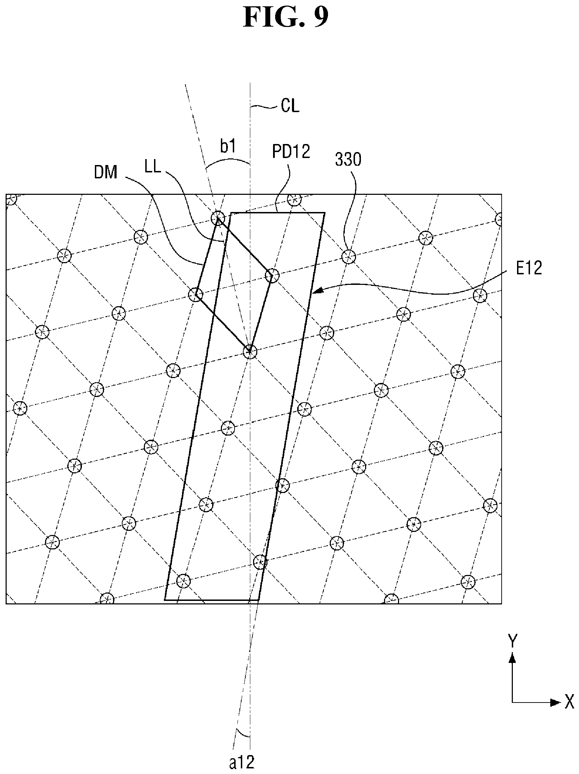

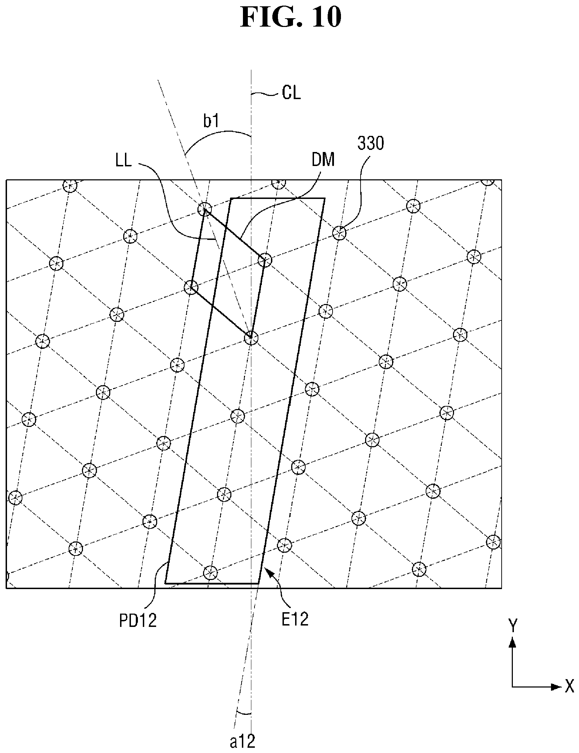

FIG. 6 is a plan view illustrating a portion of the anisotropic conductive film shown in FIG. 2. FIG. 7 is an enlarged plan view of a rectangular portion shown in FIG. 6. FIG. 8 is a plan view illustrating conductive particles of an anisotropic conductive film and a first specific pad together in a display device according to an embodiment of the invention. FIG. 9 is a plan view showing conductive particles of an anisotropic conductive film and a first specific pad together in a display device according to a first comparative example, ("Comparative Example 1"), and FIG. 10 is a plan view illustrating conductive particles of an anisotropic conductive film and a first specific pad together in a display device according to a second comparative example, ("Comparative Example 2").

Referring to FIGS. 6 to 10, the plurality of conductive particles 330 of the anisotropic conductive film 300 included in the display device 1 are arranged to have a specific regularity as shown in FIGS. 6 and 7. The conductive particles 330 may be disposed at vertices of an imaginary quadrangle DM of which a length of a first diagonal line SL is shorter than a length of a second diagonal line LL. It is to be understood that as used herein, the term "imaginary" means a quadrangle that does not exist in reality but is imagined to exist for understanding the arrangement of real I structures. For example, the imaginary quadrangles DM are imaginary constructions used to help understand the arrangement of the conductive particles 330. In particular, the arrangement of the conductive particles 330 are explained as being disposed at the vertices of a grid of regularly distributed rhombuses, as illustrated in the figures.

The arrangement of the conductive particles 330 may alternatively be described as being in a staggered matrix as the arrangement includes regular rows but columns that are staggered, or regular columns but rows that are staggered. This arrangement may also be referred to herein as a triangular lattice.

In some embodiments of the invention, the imaginary quadrangle DM may be a rectangle and/or a rhombus, having a same value r in lengths of a first side S1, a second side S2, a third side S3, and a fourth side S4. When the imaginary quadrangle DM is a rhombus, the first diagonal line SL and the second diagonal line LL of the imaginary quadrangle DM may be perpendicular to each other.

According to the invention, the imaginary quadrangle DM is a rhombus, and has a quadrangle in which two equilateral triangles are coupled, for example, a rhombus quadrangle having the value r of the length of the first diagonal line SL which is equal to the length of each of the first side S1, the second side S2, the third side S3, and the fourth side S4. Therefore, a distance between the conductive particles 330 closest to each other is constant.

When the distance between the conductive particles 330 is too small, a short circuit may occur between adjacent conductive particles 330 in the insulating direction. Further, when the distance between the conductive particles 330 is too large, an open circuit may occur within the conductive direction. Therefore, in order to ensure the electrical connection between the pad of the display panel 100 and the connection electrode of the printed circuit board 210 without causing a short circuit, the conductive particles 330 are arranged at regular intervals, and particularly, the distance between the conductive particles 330 is constant. In the display device 1, according to an embodiment of the invention, the conductive particles 330 of the anisotropic conductive film 300 are disposed at the vertices of the imaginary quadrangle DM having a quadrangle in which two equilateral triangles are coupled, and thus it is possible to prevent a short-circuit failure or a defect of electrical disconnection.

However, the shape of the imaginary quadrangle DM is not limited to the rhombus described above. In the process of applying the pressure to the anisotropic conductive film 300, the arrangement of the conductive particles 330 may be partially changed. In this case, the shape of the imaginary quadrangle DM has the same value r as the lengths of the first side S1, the second side S2, the third side S3, and the fourth side S4, but may be a rhombus in which the length of the first diagonal line SL has a different value from that of the length of the first side S1 or the like. Alternatively, the imaginary quadrangle DM may have a parallelogram shape, or have yet a different shape. For example, in some cases, the shape of the imaginary quadrangle DM may be changed within a limit that the length of the first diagonal line SL is shorter than the length of the second diagonal line LL.

The second diagonal line LL of the imaginary quadrangle DM may be tilted with respect to the Y axis or the reference line CL parallel to the Y axis. In some exemplary embodiments of the present disclosure, an acute angle formed by the second diagonal line LL and the Y axis or the reference line CL may be a seventh angle b1, and the seventh angle b1 may be greater than 0° and less than or equal to 15°.

Referring to a relationship between the first specific pad PD12 and the arrangement of the conductive particles 330, as shown in FIG. 8, the seventh angle b1 formed by the second diagonal line LL of the imaginary quadrangle DM and the Y axis (or the reference line CL) may be smaller than the second angle a12 formed by the lateral side E12 of the first specific pad PD12 and the Y axis (or the reference line CL).

As described above, in some embodiments of the invention, the second angle a12, which is an acute angle, may be greater than 5° and less than or equal to 20°, and the seventh angle b1, which is an acute angle, may be greater than 0° and less than or equal to 15°. Further, the seventh angle b1 may be smaller than the second angle a12 while both the range of the second angle a12 and the range of the seventh angle b1 described above are satisfied.

Each of the first side S1, the second side S2, the third side S3, and the fourth side S4 of the imaginary quadrangle DM might not be parallel to the Y axis, and may also not be parallel to the lateral side E12 of the first specific pad PD12. That is, the imaginary quadrangle DM might not include a side parallel to the Y axis, and might not include a side parallel to the lateral side E12 of the first specific pad PD12.

When the imaginary quadrangle DM is a rhombus in which two equilateral triangles are coupled, one side of the imaginary quadrangle DM is parallel to the lateral side E12 of the first specific pad PD12 when the sum of the seventh angle b1 and the second angle a12 are 30°. Therefore, in order to prevent the above configuration, when the imaginary quadrangle DM is a rhombus in which two equilateral triangles are coupled, the second angle a12 may be greater than 5° and less than or equal to 20°, the seventh angle b1, which is an acute angle, may be greater than 0° and less than or equal to 15°, the seventh angle b1 may be smaller than the second angle a12, and the sum of the seventh angle b1 and the second angles a12 may be smaller than 30°.

The first specific pad PD12 has a shape tilted with respect to the Y axis as described above. In this case, the number of the conductive particles 330 arranged on the first specific pad PD12 may be changed according to the arrangement of the conductive particles 330. For example, when the angle formed by the lateral side E12 of the first specific pad PD1 and the Y axis is greater than 5°, the arrangement of the conductive particles 330 may have a greater effect on the number of the conductive particles 330 arranged on the first specific pad PD12.

As the number of the conductive particles 330 arranged on the first specific pad PD12 increases, the first specific pad PD12 and the first specific connection electrode CN12 may be electrically connected more stably. Further, as the number of the conductive particles 330 arranged on the first specific pad PD12 increases, the number of the conductive particles 330 which are not arranged on the first specific pad PD12 decreases, and thus the probability of occurrence of a short circuit between adjacent pads is reduced by the conductive particles 330.

According to an embodiment of the invention, when the seventh angle b1 formed by the second diagonal line LL of the imaginary quadrangle DM and the Y axis (or the reference line CL) is smaller than the second angle a12 formed by the lateral side E12 of the first specific pad PD12 and the Y axis (or the reference line CL), the number of the conductive particles 330 overlapping the first specific pad PD12 increases. Accordingly, the reliability of electrical connection between the first specific pad PD12 and the first specific connection electrode CN12 may be increased, and the probability of a short circuit occurring between adjacent pads may be reduced.

For example, according to an embodiment of the invention, the number of the conductive particles 330 overlapping the first specific pad PD12 is about eight as shown in FIG. 8.

Referring to FIG. 9, the display device according to Comparative Example 1 illustrates the case in which the seventh angle b1 and the second angle a12 are substantially equal. According to Comparative Example 1, the number of the conductive particles 330 overlapping the first specific pad PD12 is about six.

Referring to FIG. 10, the display device according to Comparative Example 2 illustrates the case in which the seventh angle b1 is greater than the second angle a12, and particularly, illustrates the case in which one side of the imaginary quadrangle DM is parallel to the lateral side E12 of the first specific pad PD12. According to Comparative Example 2, the number of the conductive particles 330 overlapping the first specific pad PD12 is about five.

For example, the number of the conductive particles 330 overlapping the first specific pad PD12 in the display device 1, according to embodiments of the invention, may be greater than the number of the conductive particles 330 overlapping the first specific pad PD12 in each of Comparative Example 1 and Comparative Example 2. As a result, the display device 1 according to embodiments of the invention, has increased reliability in electrical connection.

Further, as the number of the conductive particles 330 overlapping the first specific pad PD12 increases, the number of the conductive particles 330 which do not overlap the first specific pad PD12 decreases. Therefore, the display device 1, according to embodiments of the invention, has a lower probability of occurrence of a short-circuit failure than in the Comparative Example 1 and the Comparative Example 2.

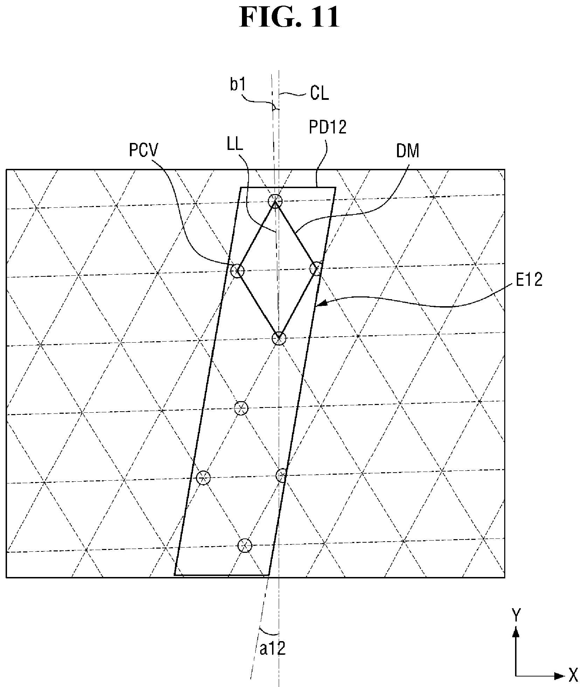

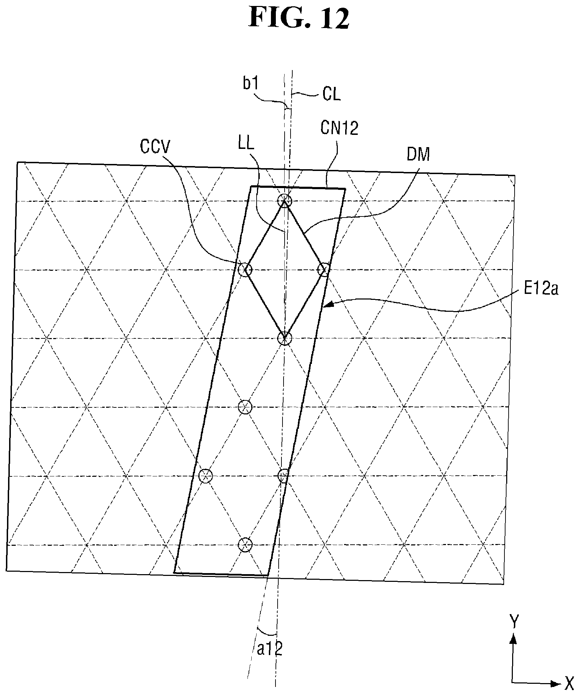

FIG. 11 is a plan view illustrating the first specific pad of FIG. 8, and FIG. 12 is a plan view illustrating the first specific connection electrode corresponding to the first specific pad of FIG. 8.

Referring to FIGS. 11 and 12, the first specific pad PD12 includes a plurality of pad concave portions PCV corresponding to the plurality of conductive particles 330 overlapping the plurality of pad concave portions PCV. Further, the first specific connection electrode CN12 corresponding to the first specific pad PD12 includes a plurality of electrode concave portions CCV corresponding to the respective pad concave portions PCV. The arrangement of the pad concave portions PCV may be substantially the same as the arrangement of the conductive particles 330 overlapping the first specific pad PD12. Therefore, like the conductive particles 330, the pad concave portions PCV may be disposed at vertices overlapping the first specific pad PD12, among the vertices of the imaginary quadrangle DM.

An acute angle formed by the second diagonal line LL of the imaginary quadrangle DM and the Y axis may be the seventh angle b1, like the conductive particles 330, and the seventh angle b1 may be smaller than the second angle a12 formed by the lateral side E12 of the first specific pad PD12 and the Y axis (or the reference line CL). In some exemplary embodiments of the present disclosure, the second angle a12, which is an acute angle, may be greater than 5° and less than or equal to 20°, and the seventh angle b1, which is an acute angle, may be greater than 0° and less than or equal to 15°. Further, the seventh angle b1 may be smaller than the second angle a12 while both the range of the second angle a12 and the range of the seventh angle b1 described above are satisfied. In addition, the description of the arrangement of the pad concave portions PCV and the relationship between the lateral side E12 of the first specific pad PD12 and the arrangement of the pad concave portions PCV are the same as those described above in the description of the conductive particles 330.

Similarly, the arrangement of the electrode concave portions CCV may be substantially the same as the arrangement of the conductive particles 330 overlapping the first specific connection electrode CN12 or the arrangement of the pad concave portions PCV. In addition, the acute angle formed by the lateral side E12a of the first specific connection electrode CN12 and the Y axis may be substantially equal to the second angle a12, and the shape of the first specific connection electrode CN12 may be substantially the same as that of the first specific pad PD12. Therefore, the relationship between the electrode concave portions CCV and the first specific connection electrode CN12 is the same as that described above in the description of the conductive particles 330.

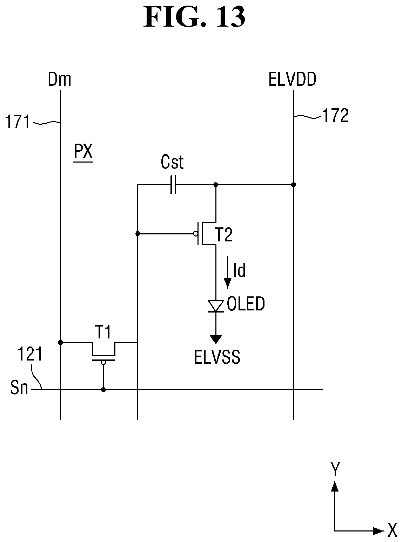

Hereinafter, the structure of the display panel 100 in the display region of the display device 1 will be described in detail with reference to FIGS. 13 to 15.

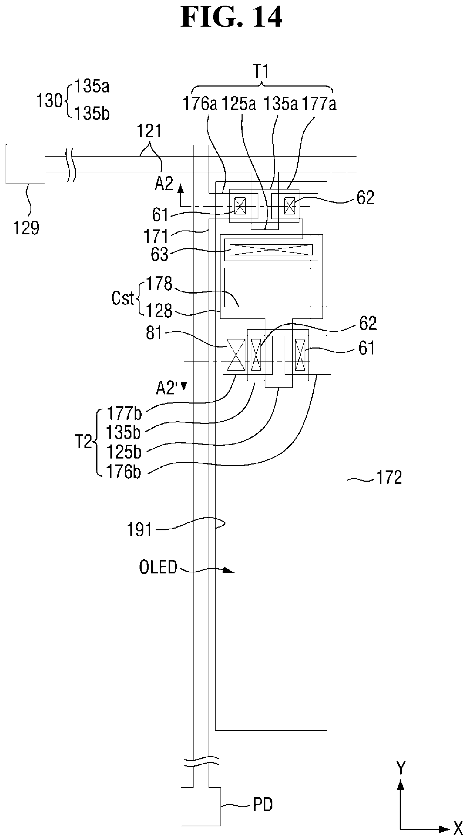

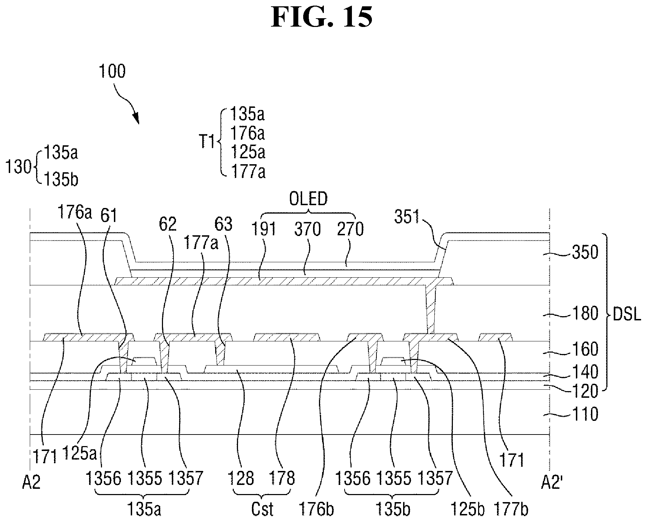

FIG. 13 is an equivalent circuit diagram illustrating a pixel of FIG. 1, FIG. 14 is a plan view schematic circuit diagram illustrating a pixel of FIG. 1, and FIG. 15 is a cross-sectional view taken along line A2-A2' of FIG. 14.

Referring to FIGS. 13 to 15, one pixel PX of the display device may include a plurality of signal lines 121, 171, and 172, a plurality of transistors T1 and T2 connected to the plurality of signal lines 121, 171, and 172, a storage capacitor Cst, and an organic light-emitting diode OLED as shown in FIG. 13.

The transistors T1 and T2 include a switching transistor T1 and a driving transistor T2.

The signal lines 121, 171, and 172 include a plurality of gate lines 121 which transmit gate signals Sn (also referred to as scan signals), a plurality of data lines 171 which cross the gate lines 121 and transmit data signals Dm, and a plurality of driving voltage lines 172 which transmit a driving voltage ELVDD and extend in a direction parallel to the data lines 171. FIG. 12 shows one gate line 121, one data line 171, and one driving voltage line 172 as an example showing one pixel connected to one gate line 121, one data line 171, and one driving voltage line 172, and in actuality, a plurality of gate lines 121, a plurality of data lines 171, and a plurality of driving voltage lines 172 may be formed. In some exemplary embodiments of the present disclosure, the plurality of gate lines 121 may extend in a direction parallel to the X axis, and the plurality of data lines 171 and the plurality of driving voltage lines 172 may extend in a direction parallel to the Y axis.

The switching transistor T1 has a control terminal, an input terminal, and an output terminal. The control terminal of the switching transistor T1 is connected to the gate line 121, the input terminal is connected to the data line 171, and the output terminal is connected to the driving transistor T2. The switching transistor T1 transmits the data signal Dm applied to the data line 171 to the driving transistor T2 in response to the gate signal Sn applied to the gate line 121.

The driving transistor T2 also has a control terminal, an input terminal, and an output terminal. The control terminal of the driving transistor T2 is connected to the switching transistor T1, the input terminal is connected to the driving voltage line 172, and the output terminal is connected to the organic light-emitting diode OLED. The driving transistor T2 flows a driving current Id whose magnitude varies according to a voltage applied between the control terminal and the output terminal.

The storage capacitor Cst is connected between the control terminal and the input terminal of the driving transistor T2. The storage capacitor Cst charges the data signal applied to the control terminal of the driving transistor T2 and maintains the data signal after the switching transistor T1 is turned off.

The organic light-emitting diode OLED has an anode connected to the output terminal of the driving transistor T2, and a cathode connected to a common voltage ELVSS. The organic light-emitting diode OLED emits light with intensity that depends on the magnitude of the driving current Id of the driving transistor T2. The luminance of each pixel is adjusted by adjusting the emission intensity of the organic light-emitting diode OLED for each pixel, so that an image is displayed.

A connection relationship between the transistors T1 and T2, the storage capacitor Cst, and the organic light-emitting diode OLED is not limited to that described above, and may be variously changed.

Referring to FIGS. 14 and 15, a display element layer DSL is disposed on the base substrate 110.

Hereinafter, a structure of the display element layer DSL will be described.

A buffer layer 120 is disposed on the base substrate 110, and a semiconductor layer 130 is formed on the buffer layer 120. The semiconductor layer 130 includes a switching semiconductor layer 135a and a driving semiconductor layer 135b, which are formed at positions spaced apart from each other. The semiconductor layer 130 may be made of a polycrystalline silicon material or an oxide semiconductor material.

Each of the switching semiconductor layer 135a and the driving semiconductor layer 135b includes a channel 1355, and includes a source region 1356 and a drain region 1357 which are disposed at both sides of the channel 1355.

A gate insulating film 140 may be disposed on the switching semiconductor layer 135a and the driving semiconductor layer 135b. The gate lines 121, a switching gate electrode 125a, a driving gate electrode 125b, and a first storage capacitor plate 128 may be disposed on the gate insulating film 140.

The gate lines 121 may extend in the X axis direction and may transmit the gate signal Sn. The switching gate electrode 125a protrudes from the gate lines 121 over the switching semiconductor layer 135a. The driving gate electrode 125b protrudes from the first storage capacitor plate 128 over the driving semiconductor layer 135b. Each of the switching gate electrode 125a and the driving gate electrode 125b at least partially overlaps the channel 1355.

A gate pad 129 connected to an end of the gate line 121 is disposed on the gate insulating film 140. The gate pad 129 is disposed in the non-display region NA of the display panel 100.

An interlayer insulating film 160 is disposed on the gate insulating film 140, the gate lines 121, the driving gate electrode 125b, and the first storage capacitor plate 128, and contact holes 61 and 62 are formed in the gate insulating film 140 and the interlayer insulating film 160 to expose at least a portion of an upper surface of the semiconductor layer 130. For example, the contact holes 61 and 62 may expose the source region 1356 and the drain region 1357 of the semiconductor layer 130. Further, a storage contact hole 63 overlapping a portion of the first storage capacitor plate 128 may be formed in the interlayer insulating film 160.

The data lines 171, the driving voltage line 172, a switching source electrode 176a, a driving source electrode 176b, a second storage capacitor plate 178, a switching drain electrode 177a, and a driving drain electrode 177b may be disposed on the interlayer insulating film 160.

The data line 171 transmits the data signal Dm, crosses the gate lines 121, and extends in the Y axis direction. The driving voltage line 172 transmits the driving voltage ELVDD, and is separated from the data line 171 to extend in a direction parallel to the data line 171.

The switching source electrode 176a may protrude from the data line 171 toward the switching semiconductor layer 135a, and the driving source electrode 176b may protrude from the driving voltage line 172 toward the driving semiconductor layer 135b. Each of the switching source electrode 176a and the driving source electrode 176b is connected to the source region 1356 through the contact hole 61.

Each of the switching drain electrode 177a and the driving drain electrode 177b is connected to the drain region 1357 through the contact hole 62.

The switching drain electrode 177a may extend to be electrically connected to the first storage capacitor plate 128 and the driving gate electrode 125b through the storage contact hole 63 formed in the interlayer insulating film 160.

The second storage capacitor plate 178 may protrude from the driving voltage lines 172 and may be polymerized with the first storage capacitor plate 128, and the first storage capacitor plate 128 and the second storage capacitor plate 178 may form the storage capacitor Cst using the interlayer insulating film 160 as a dielectric.

The switching semiconductor layer 135a, the switching gate electrode 125a, the switching source electrode 176a, and the switching drain electrode 177a form the switching transistor T1, and the driving semiconductor layer 135b, the driving gate electrode 125b, the driving source electrode 176b, and the driving drain electrode 177b form the driving transistor T2.

In some exemplary embodiments of the present disclosure, the data line 171 may be electrically connected to the pad PD disposed in the pad region MA of the display panel 100. For example, the end of the data line 171 may be connected to the pad PD, but the present disclosure is not limited thereto. In some exemplary embodiments of the present disclosure, the data line 171 and the pad PD may be electrically connected to each other through a separate wire.

A protective film 180 is formed on the data lines 171, the driving voltage lines 172, the switching source electrode 176a, the driving source electrode 176b, the second storage capacitor plate 178, the switching drain electrode 177a, and the driving drain electrode 177b. A contact hole 81 is formed in the protective film 180 to expose at least a portion of the driving drain electrode 177b.

A pixel electrode 191 is formed on the protective film 180. The pixel electrode 191 is electrically connected to the driving drain electrode 177b of the driving transistor T2 through the contact hole 81, and is an anode electrode of the organic light-emitting diode OLED.

A pixel definition film 350 is formed on the protective film 180. The pixel definition film 350 has a pixel opening 351 overlapping the pixel electrode 191.

An organic light-emitting layer 370 may be disposed in the pixel opening 351 of the pixel definition film 350. The organic light-emitting layer 370 may include a plurality of layers including at least one of a light-emitting layer, a hole injecting layer (HIL), a hole transporting layer (HTL), an electron transporting layer (ETL), and an electron injecting layer (EIL). When the organic light-emitting layer 370 includes all of the above layers, the HIL may be disposed on the pixel electrode 191, which is an anode electrode, and the HTL, the light-emitting layer, the ETL, and the EIL may be sequentially stacked on the HIL.

In some exemplary embodiments of the present disclosure, the organic light-emitting layer 370 may include a red organic light-emitting layer which emits red light, a green organic light-emitting layer which emits green light, or a blue organic light-emitting layer which emits blue light. The red organic light-emitting layer, the green organic light-emitting layer, and the blue organic light-emitting layer are formed in a red pixel, a green pixel, and a blue pixel, respectively, to realize a color image.

A common electrode 270 is disposed on the pixel definition film 350 and the organic light-emitting layer 370. The common electrode 270 becomes a cathode electrode of the organic light-emitting diode OLED. The pixel electrode 191, the organic light-emitting layer 370, and the common electrode 270 form the organic light-emitting diode OLED.

The case in which the display device, according to exemplary embodiments of the present disclosure, is an organic light-emitting display device has been described above.

However, the present disclosure is not limited thereto, and the display device, according to exemplary embodiments of the present disclosure may be a display device other than the organic light-emitting display device, for example, a liquid crystal display device or the like.

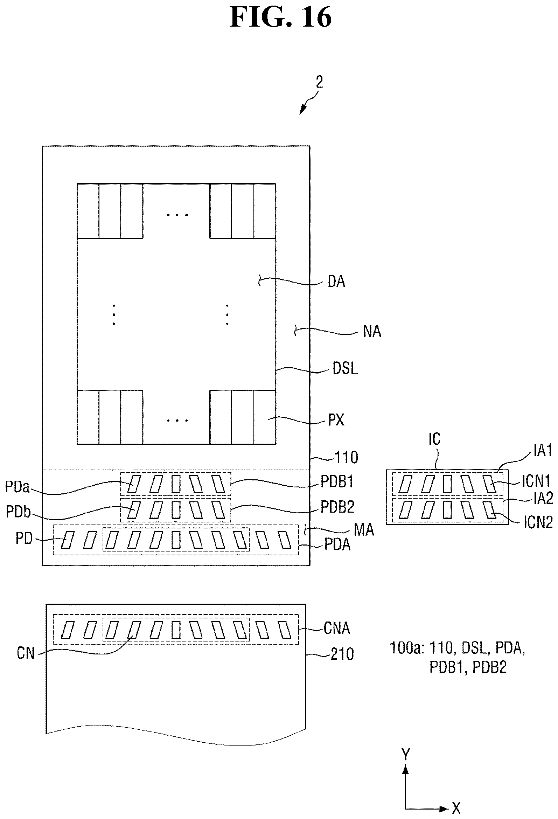

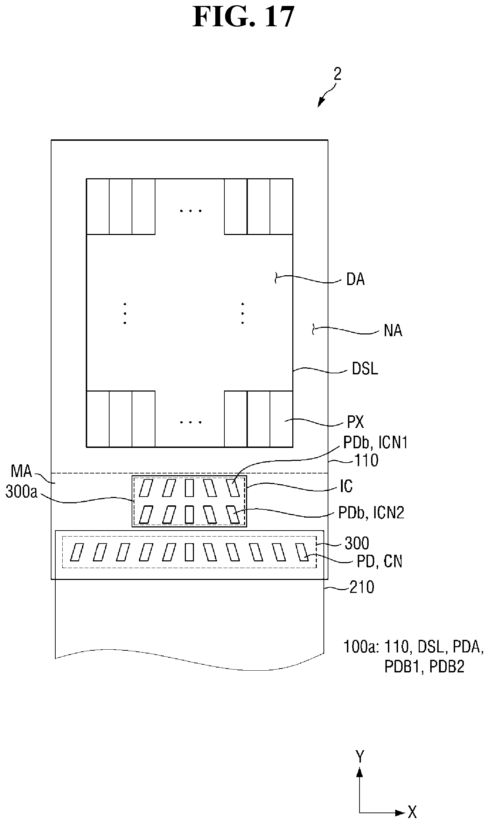

FIGS. 16 and 17 are plan views showing a bonding process of a display panel and a printed circuit board in a display device according to an embodiment of the invention.

Referring to FIGS. 16 and 17, a display device 2, according to an embodiment of the invention, includes a display panel 100a, a data driving IC formed in the form of a chip, which is mounted on the display panel 100a, and a printed circuit board 210.

The display panel 100a differs from the display panel 100 of the display device 1 shown in FIGS. 1 and 2 in that a pad region MA includes a first chip pad portion PDB1 and a second chip pad portion PDB2 which are electrically connected to the data driving IC formed in the form of a chip, and other elements of the display panel 100a are substantially the same as or similar to those of the display panel 100 of the display device 1 shown in FIGS. 1 and 2. Therefore, to the extent that descriptions of some elements is not provided, it may be assumed that the undescribed elements are at least similar to those of the display panel 100 of the display device 1 shown in FIGS. 1 and 2 that have already been described.

The first chip pad portion PDB1 is electrically connected to the data driving IC and the data line of the display element layer DSL and transmits a driving signal from the data driving IC to the pixel PX of the display element layer DSL. In some exemplary embodiments of the present disclosure, the first chip pad portion PDB1 may include a plurality of first chip pads PDa, and some of the first chip pads PDa may have a shape tilted with respect to the Y axis, similar to the pads PD of the pad portion PDA.

The second chip pad portion PDB2 is a portion which electrically connects the data driving IC to the pad portion PDA, and transmits a control signal or power from a main circuit board or the like electrically connected to the printed circuit board 210, to the data driving IC. In some exemplary embodiments of the present disclosure, the second chip pad portion PDB2 may include a plurality of second chip pads PDb, and some of the second chip pads PDb may have a shape tilted with respect to the Y axis, similar to the pads PD of the pad portion PDA.

The data driving IC may include a first circuit pad portion IA1 and a second circuit pad portion IA2 on a surface facing the display panel 100a, for example, on a rear surface of the printed circuit board 210.

The first circuit pad portion IA1 may be electrically connected to the first chip pad portion PDB1, and the second circuit pad portion IA2 may be electrically connected to the second chip pad portion PDB2.

The first circuit pad portion IA1 may include a plurality of first circuit pads ICN1, and the first circuit pad ICN1 may have a shape corresponding to the first chip pad PDa.

The second circuit pad portion IA2 may include a plurality of second circuit pads ICN2, and the second circuit pad ICN2 may have a shape corresponding to the second chip pad PDb.

An anisotropic conductive film 300a may be disposed between the display panel 100a and the data driving IC formed in the form of a chip, and the display panel 100a and the data driving IC may be physically and/or electrically coupled to each other through the anisotropic conductive film 300a.

For example, in some embodiments of the invention, when the base substrate 110 of the display panel 100a is made of glass, the data driving IC may be mounted on the display panel 100a in the form of a chip-on-glass (COG), or when the base substrate 110 of the display panel 100a is made of plastic or the like, the data driving IC may be mounted on the display panel 100a in the form of a chip-on-plastic (COP).

The anisotropic conductive film 300a may have substantially the same structure as the anisotropic conductive film 300. For example, the anisotropic conductive film 300a may include an insulating layer and a plurality of conductive particles disposed in the insulating layer, and the conductive particles in the anisotropic conductive film 300a may be arranged in the same manner as the conductive particles 330 of the anisotropic conductive film 300.

The first circuit pads ICN1 and the first chip pads PDa may be electrically connected to each other through the conductive particles of the anisotropic conductive film 300a. In the same manner, the second circuit pads ICN2 and the second chip pads PDb may be electrically connected to each other through the conductive particles of the anisotropic conductive film 300a.

A relationship between an arrangement of the conductive particles in the anisotropic conductive film 300a and the tilted angle of the first chip pad PDa, a relationship between an arrangement of the conductive particles in the anisotropic conductive film 300a and the tilted angle of the second chip pad PDb, and the like may be substantially the same as or similar to the relationship between the arrangement of the conductive particles 330 in the anisotropic conductive film 300 and the first specific pad PD12 described above.

According to the embodiments of the invention, a display device having increased reliability can be provided.

It is clear for a person skilled in the art that the disclosed embodiments can also be combined where possible.

## Claims

1. A display device comprising:
a display panel (100) including
a display region (DA) and
a pad region (MA) disposed in a periphery of the display region and including a pad portion (PDA) ;
a circuit substrate (210) electrically connected to the pad portion; and
an anisotropic conductive film (300) interposed between the pad portion (PDA) and the circuit substrate (210),
wherein the pad portion (PDA) includes a first pad (PG1) of which a lateral side and a Y axis that runs along a lengthwise direction of the display panel form a first angle (a11) greater than 0°,
wherein the anisotropic conductive film (300) includes a plurality of conductive particles,
wherein the plurality of conductive particles are disposed at vertices of an imaginary quadrangle having a first diagonal line (SL) and a second diagonal line (LL), the quadrangle being a rhombus in which two equilateral triangles are coupled , and a length of the first diagonal line (SL) is smaller than a length of the second diagonal line (LL), wherein the second diagonal line (LL) and the Y axis form a second angle greater than 0°,
wherein the first angle and the second angle are acute angles,
wherein the first angle is greater than the second angle,
wherein each conductive particle at each vertex is adjacent to one another such that a distance between every pair of two conductive particles (330) closest to each other is constant.

2. The display device of claim 1, wherein the first angle is greater than 5° and less than or equal to 20° and the second angle is 15° or less.

3. The display device of claim 1 or 2, wherein the imaginary quadrangle does not include a side parallel to the lateral side of the first pad (PG1).

4. The display device of one of the preceding claims, wherein:
a length of a side of the rhombus is the same as the length of the first diagonal line (SL), and
a sum of the first angle and the second angle is less than 30°.

5. The display device of one of the preceding claims, wherein:
the first pad (PG1) has a parallelogram shape having a height greater than a length of a base;
the base of the first pad (PG1) is parallel to an X axis that is perpendicular to the Y axis;
the height of the first pad (PG1) is a length in the Y axis direction;
the first pad includes a plurality of pads (PD11, PD12, PD13), the base of each pad (PD11, PD12, PD13) being arranged parallel to the X axis; and
the nearer to an edge of the display panel a pad (PD11, PD12, PD13) of the first pad (PG1) is arranged in the X-axis direction, the greater the first angle (a11) of the pad (PD11, PD12, PD13) is.

6. The display device of one of the preceding claims, wherein:
the pad portion (PDA) further includes a second pad (PG2) of which a lateral side and the Y axis form a third angle (a21), the third angle being an acute angle;
the second pad (PG2) is symmetrical to the first pad (PG1) on the basis of the Y axis;
the second pad (PG2) includes a plurality pads (PD21, PD22, PD23), the base of each pad (PD21, PD22, PD23) being arranged parallel to the X axis that is perpendicular to the Y axis; and
the nearer to an edge of the display panel a pad (PD21, PD22, PD23) of the second pad (PG2) is arranged in the X-axis direction, the greater the third angle (a21) of the pad (PD21, PD22, PD23) is.

7. The display device of claim 6, wherein the pad portion (PDA) further includes a reference pad (PDC) which is disposed between the first pad (PG1) and the second pad (PG2) and has a lateral side parallel to the Y axis.

8. The display device of one of the preceding claims, wherein:
the display panel includes
a data line (171) which is disposed in the display region and extends in the Y axis direction,
a transistor (T1, T2) connected to the data line (171), and
an organic light-emitting diode connected to the transistor; and
the first pad (PG1) is electrically connected to the data line (171).

9. The display device of one of the preceding claims, wherein:
the circuit substrate (210) includes a connection electrode (CAN) at least partially overlapping the first pad (PG1) and the circuit substrate (210) is electrically connected to the first pad (PG1) through the plurality of conductive particles; and
a lateral side of the connection electrode (CAN) and the Y axis form the first angle.

10. The display device of claim 9, wherein:
the connection electrode (CAN) has a parallelogram shape having a height greater than a length of a base;
the base of the connection electrode (CAN) is parallel to the X axis; and
the height of the connection electrode (CAN) is a length in the Y axis direction.

11. The display device of claim 9 or 10, wherein:
the first pad (PG1) includes a pad concave portion (PCV);
the connection electrode (CAN) includes an electrode concave portion (CCV) at least partially overlapping the pad concave portion (PCV); and
the conductive particles (CAN) are disposed between the pad concave portion (PCV) and the electrode concave portion (CCV).

12. The display device of one of the preceding claims , wherein the circuit substrate (210) is a flexible printed circuit board.

## Patentansprüche

1. Eine Anzeigevorrichtung, die Folgendes umfasst:
eine Anzeigetafel (100) mit
einen Anzeigebereich (DA) und
einen Pad-Bereich (MA), der in einem Randbereich des Anzeigebereichs angeordnet ist und einen Pad-Abschnitt (PDA) enthält;
ein Schaltungssubstrat (210), das elektrisch mit dem Kontaktflächenabschnitt verbunden ist; und
einen anisotropen leitfähigen Film (300), der zwischen dem Pad-Abschnitt (PDA) und dem Schaltungssubstrat (210) angeordnet ist,
wobei der Pad-Abschnitt (PDA) ein erstes Pad (PG1) umfasst, von dem eine seitliche Seite und eine Y-Achse, die entlang einer Längsrichtung der Anzeigetafel verläuft, einen ersten Winkel (a11) größer als 0° bilden,
wobei der anisotrope leitfähige Film (300) eine Vielzahl von leitfähigen Partikeln enthält,
wobei die Vielzahl von leitfähigen Teilchen an den Eckpunkten eines imaginären Vierecks mit einer ersten Diagonalen (SL) und einer zweiten Diagonalen (LL) angeordnet sind, wobei das Viereck ein Rhombus ist, in dem zwei gleichseitige Dreiecke verbunden sind, und eine Länge der ersten Diagonalen (SL) kleiner ist als eine Länge der zweiten Diagonalen (LL), wobei die zweite Diagonale (LL) und die Y-Achse einen zweiten Winkel größer als 0° bilden,
wobei der erste Winkel und der zweite Winkel spitze Winkel sind,
wobei der erste Winkel größer als der zweite Winkel ist,
wobei jedes leitende Teilchen an jedem Scheitelpunkt so an ein benachbartes Teilchen angrenzt, dass der Abstand zwischen jedem Paar von zwei einander nächstgelegenen leitenden Teilchen (330) konstant ist.

2. Die Anzeigevorrichtung nach Anspruch 1, wobei der erste Winkel größer als 5° und kleiner als oder gleich 20° ist und der zweite Winkel 15° oder kleiner ist.

3. Die Anzeigevorrichtung nach Anspruch 1 oder 2, wobei das imaginäre Viereck keine Seite enthält, die parallel zu der seitlichen Seite des ersten Pads (PG1) verläuft.

4. Die Anzeigevorrichtung nach einem der vorhergehenden Ansprüche, wobei:
die Länge einer Seite des Rhombus ist gleich der Länge der ersten Diagonalen (SL), und
die Summe des ersten Winkels und des zweiten Winkels weniger als 30° beträgt.

5. Die Anzeigevorrichtung nach einem der vorhergehenden Ansprüche, wobei:
das erste Kissen (PG1) hat die Form eines Parallelogramms mit einer Höhe, die größer ist als die Länge einer Basis;
die Basis des ersten Pads (PG1) parallel zu einer X-Achse liegt, die senkrecht zur Y-Achse verläuft;
die Höhe des ersten Pads (PG1) ist eine Länge in Richtung der Y-Achse;
das erste Kissen umfasst eine Vielzahl von Kissen (PD11, PD12, PD13), wobei die Basis jedes Kissens (PD11, PD12, PD13) parallel zur X-Achse angeordnet ist; und
je näher an einer Kante der Anzeigetafel ein Pad (PD11, PD12, PD13) des ersten Pads (PG1) in Richtung der X-Achse angeordnet ist, desto größer ist der erste Winkel (a11) des Pads (PD11, PD12, PD13).

6. Die Anzeigevorrichtung nach einem der vorhergehenden Ansprüche, wobei:
der Polsterteil (PDA) ferner ein zweites Polster (PG2) umfasst, bei dem eine seitliche Seite und die Y-Achse einen dritten Winkel (a21) bilden, wobei der dritte Winkel ein spitzer Winkel ist;
das zweite Pad (PG2) ist symmetrisch zum ersten Pad (PG1) in Bezug auf die Y-Achse;
das zweite Kissen (PG2) eine Vielzahl von Kissen (PD21, PD22, PD23) umfasst, wobei die Basis jedes Kissens (PD21, PD22, PD23) parallel zur X-Achse angeordnet ist, die senkrecht zur Y-Achse verläuft; und
je näher an einer Kante der Anzeigetafel ein Pad (PD21, PD22, PD23) des zweiten Pads (PG2) in Richtung der X-Achse angeordnet ist, desto größer ist der dritte Winkel (a21) des Pads (PD21, PD22, PD23).

7. Die Anzeigevorrichtung nach Anspruch 6, wobei der Pad-Abschnitt (PDA) ferner ein Referenz-Pad (PDC) umfasst, das zwischen dem ersten Pad (PG1) und dem zweiten Pad (PG2) angeordnet ist und eine seitliche Seite parallel zur Y-Achse hat.

8. Die Anzeigevorrichtung nach einem der vorhergehenden Ansprüche, wobei:
die Anzeigetafel umfasst
eine Datenleitung (171), die in dem Anzeigebereich angeordnet ist und sich in Richtung der Y-Achse erstreckt,
einen Transistor (T1, T2), der mit der Datenleitung (171) verbunden ist, und
eine organische Leuchtdiode, die mit dem Transistor verbunden ist; und
das erste Pad (PG1) ist elektrisch mit der Datenleitung (171) verbunden.

9. Die Anzeigevorrichtung nach einem der vorhergehenden Ansprüche, wobei:
das Schaltungssubstrat (210) eine Anschlusselektrode (CAN) aufweist, die zumindest teilweise die erste Anschlussfläche (PG1) überlappt, und das Schaltungssubstrat (210) mit der ersten Anschlussfläche (PG1) durch die Vielzahl von leitenden Teilchen elektrisch verbunden ist; und
eine seitliche Seite der Anschlusselektrode (CAN) und die Y-Achse bilden den ersten Winkel.

10. Die Anzeigevorrichtung nach Anspruch 9, wobei:
die Anschlusselektrode (CAN) hat die Form eines Parallelogramms mit einer Höhe, die größer ist als die Länge einer Basis;
die Basis der Anschlusselektrode (CAN) ist parallel zur X-Achse; und
die Höhe der Anschlusselektrode (CAN) ist eine Länge in Richtung der Y-Achse.

11. Die Anzeigevorrichtung nach Anspruch 9 oder 10, wobei:
das erste Kissen (PG1) enthält einen konkaven Teil (PCV);
die Anschlusselektrode (CAN) einen konkaven Elektrodenabschnitt (CCV) aufweist, der den konkaven Polsterabschnitt (PCV) zumindest teilweise überlappt; und
die leitenden Partikel (CAN) zwischen dem konkaven Teil des Pads (PCV) und dem konkaven Teil der Elektrode (CCV) angeordnet sind.

12. Die Anzeigevorrichtung nach einem der vorhergehenden Ansprüche, wobei das Schaltungssubstrat (210) eine flexible Leiterplatte ist.

## Revendications

1. Un dispositif d'affichage comprenant :
un panneau d'affichage (100) comprenant
une région d'affichage (DA) et
une région de bloc (MA) disposée dans une périphérie de la région d'affichage et comprenant une partie de bloc (PDA) ;
un substrat de circuit (210) connecté électriquement à la partie de plage de connexion ; et
un film conducteur anisotrope (300) interposé entre la partie tampon (PDA) et le substrat de circuit (210),
dans lequel la partie tampon (PDA) comprend un premier tampon (PG1) dont un côté latéral et un axe Y qui s'étend dans le sens de la longueur du panneau d'affichage forment un premier angle (a11) supérieur à 0°,
dans lequel le film conducteur anisotrope (300) comprend une pluralité de particules conductrices,
dans lequel la pluralité de particules conductrices sont disposées aux sommets d'un quadrilatère imaginaire ayant une première ligne diagonale (SL) et une seconde ligne diagonale (LL), le quadrilatère étant un losange dans lequel deux triangles équilatéraux sont couplés, et une longueur de la première ligne diagonale (SL) est inférieure à une longueur de la seconde ligne diagonale (LL), dans lequel la seconde ligne diagonale (LL) et l'axe Y forment un second angle supérieur à 0°,
dans lequel le premier angle et le second angle sont des angles aigus,
dans lequel le premier angle est supérieur au second angle,
dans lequel chaque particule conductrice à chaque sommet est adjacente à une autre de sorte qu'une distance entre chaque paire de deux particules conductrices (330) rapprochées l'une de l'autre est constante.

2. Dispositif d'affichage selon la revendication 1, dans lequel le premier angle est supérieur à 5° et inférieur ou égal à 20° et le second angle est de 15° ou moins.

3. Dispositif d'affichage selon la revendication 1 ou 2, dans lequel le quadrilatère imaginaire ne comprend pas un côté parallèle au côté latéral du premier tampon (PG1).

4. Le dispositif d'affichage de l'une des revendications précédentes, dans lequel :
une longueur d'un côté du losange est la même que la longueur de la première ligne diagonale (SL), et
la somme du premier angle et du deuxième angle est inférieure à 30°.

5. Dispositif d'affichage de l'une des revendications précédentes, dans lequel :
le premier tampon (PG1) a une forme de parallélogramme dont la hauteur est supérieure à la longueur d'une base ;
la base du premier tampon (PG1) est parallèle à un axe X qui est perpendiculaire à l'axe Y ;
la hauteur du premier tampon (PG1) est une longueur dans la direction de l'axe Y ;
le premier tampon comprend une pluralité de tampons (PD11, PD12, PD13), la base de chaque tampon (PD11, PD12, PD13) étant disposée parallèlement à l'axe X ; et
plus un tampon (PD11, PD12, PD13) du premier tampon (PG1) est disposé près d'un bord du panneau d'affichage dans la direction de l'axe X, plus le premier angle (a11) du tampon (PD11, PD12, PD13) est grand.

6. Le dispositif d'affichage de l'une des revendications précédentes, dans lequel :
la partie tampon (PDA) comprend en outre un deuxième tampon (PG2) dont un côté latéral et l'axe Y forment un troisième angle (a21), le troisième angle étant un angle aigu ;
le deuxième tampon (PG2) est symétrique au premier tampon (PG1) sur la base de l'axe Y;
le deuxième tampon (PG2) comprend une pluralité de tampons (PD21, PD22, PD23), la base de chaque tampon (PD21, PD22, PD23) étant disposée parallèlement à l'axe X qui est perpendiculaire à l'axe Y ; et
plus un tampon (PD21, PD22, PD23) du deuxième tampon (PG2) est disposé près d'un bord du panneau d'affichage dans la direction de l'axe X, plus le troisième angle (a21) du tampon (PD21, PD22, PD23) est grand.

7. Dispositif d'affichage selon la revendication 6, dans lequel la partie de coussin (PDA) comprend en outre un coussin de référence (PDC) qui est disposé entre le premier coussin (PG1) et le second coussin (PG2) et a un côté latéral parallèle à l'axe Y.

8. le dispositif d'affichage de l'une des revendications précédentes, dans lequel :
le panneau d'affichage comprend
une ligne de données (171) qui est disposée dans la zone d'affichage et s'étend dans la direction de l'axe Y,
un transistor (T1, T2) connecté à la ligne de données (171), et
une diode électroluminescente organique connectée au transistor ; et
le premier plot (PG1) est connecté électriquement à la ligne de données (171).

9. Le dispositif d'affichage de l'une des revendications précédentes, dans lequel :
le substrat de circuit (210) comprend une électrode de connexion (CAN) recouvrant au moins partiellement le premier plot (PG1) et le substrat de circuit (210) est connecté électriquement au premier plot (PG1) par l'intermédiaire de la pluralité de particules conductrices ; et
un côté latéral de l'électrode de connexion (CAN) et l'axe Y forment le premier angle.

10. Le dispositif d'affichage de la revendication 9, dans lequel :
l'électrode de connexion (CAN) a une forme de parallélogramme dont la hauteur est supérieure à la longueur d'une base ;
la base de l'électrode de connexion (CAN) est parallèle à l'axe X ; et
la hauteur de l'électrode de connexion (CAN) est une longueur dans la direction de l'axe Y.

11. Le dispositif d'affichage de la revendication 9 ou 10, dans lequel :
le premier tampon (PG1) comprend une partie concave de tampon (PCV) ;
l'électrode de connexion (CAN) comprend une partie concave d'électrode (CCV) recouvrant au moins partiellement la partie concave de tampon (PCV) ; et
les particules conductrices (CAN) sont disposées entre la partie concave du tampon (PCV) et la partie concave de l'électrode (CCV).

12. Dispositif d'affichage de l'une des revendications précédentes, dans lequel le substrat de circuit (210) est une carte de circuit imprimé flexible.
